# EUROPEAN PATENT APPLICATION

(11) **EP 2 463 411 A1**
(43) Date of publication of application: **13.06.2012**
(21) Application number: 11785275.6
(22) Date of filing: 31.01.2011
(51) Int. Cl.: C30B 1/00

(54) **PRODUCTION METHOD FOR SILICON THIN FILM, PRODUCTION METHOD FOR SILICON THIN-FILM SOLAR CELL, SILICON THIN FILM, AND SILICON THIN-FILM SOLAR CELL**

(30) Priority: 31.08.2010 JP 2010195077
(71) Applicant: Akiyama, Nobuyuki, Ibaraki 300-0427 (JP)
(72) Inventor: The designation of the inventor has not yet been filed
(74) Representative: Grünecker, Kinkeldey, Stockmair & Schwanhäusser
(86) International application number: PCT/JP2011/051958
(87) International publication number: WO 2012/029333

(57) **Abstract**

Disclosed is a method of manufacturing a silicon thin film, a method of manufacturing a silicon thin-film photovoltaic cell, and a silicon thin film. There is provided a method of manufacturing a silicon thin film in a form in which an inert face formed by an exposed face of a silicon substrate and an inert layer is formed by selectively forming the inert layer on the silicon substrate in which growth of a silicon crystal is inactive for a raw material gas of the silicon crystal, and the silicon crystal is grown from the exposed face such that the silicon crystal covers the silicon substrate by supplying a raw material gas, of which a surface decomposition reaction on the silicon substrate is dominant, out of the raw material gas to the silicon substrate. By forming a width of the exposed face in a range of 0.001 µm to 1 µm, the silicon thin film is formed in a state that the silicon thin film can be peeled off from the silicon substrate.

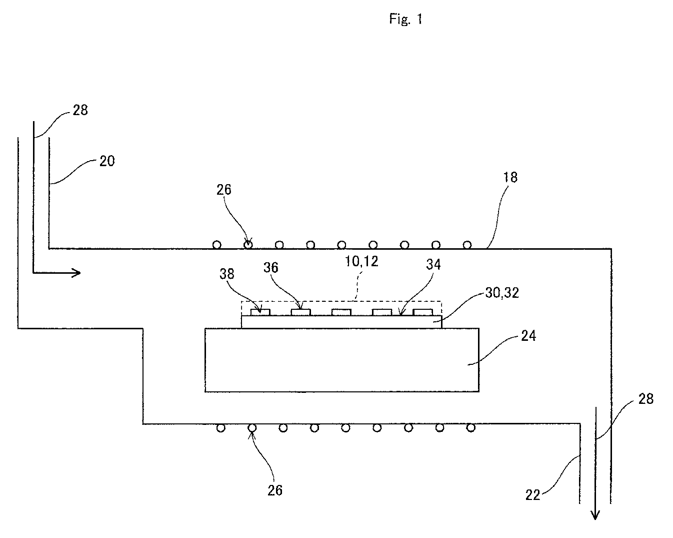

## Description

### BACKGROUND OF THE INVENTION

### 1. Field of the Invention

The present invention relates to a method of manufacturing a silicon of a thin film state, and more particularly, to a silicon thin film and a silicon thin-film photovoltaic cell that can be separately used as a thin film acquired by peeling it off from a substrate after thin-film growth and methods of manufacturing thereof.

### 2. Description of the Related Art

In a case where photovoltaic power generation is performed, silicon as a semiconductor is frequently used. Silicon is expected to raise the efficiency of the photovoltaic power generation, and a silicon element is abundantly present on the earth and is free from resource depletion, whereby the development of silicon is expected in the industry. A photovoltaic cell using silicon is expected to represent a theoretic conversion efficiency of 25%, and currently a conversion efficiency of about 20% is achieved.

A silicon wafer for photovoltaic power generation that is used for acquiring such an optical efficiency can be acquired by cutting an ingot of a single-crystal silicon formed by using a CZ method or the like or a multicrystalline silicon that is melted and solidified in a mold so as to have a thickness of about 180 µm and mirror polishing a cut face. Here, in order to cut the ingot of silicon, a wire saw is widely used. Accordingly, in order to manufacture one sheet of a silicon wafer, a cutting margin is necessary, and about a thickness of 360 µm is necessary for manufacturing one sheet of the silicon wafer in consideration of the cutting margin.

Thus, by applying a technology for allowing the silicon wafer used for a photovoltaic cell to have a thickness of about 30 micrometer, a desired electric generating capacity can be acquired. However, according to the above-described method, in order to acquire the mechanical strength of the wafer at the time of cutting, a silicon wafer having a thickness that is more than necessary needs to be formed, and a cutting margin for cutting the silicon wafer is necessary. Accordingly, most of the silicon raw material is wasted, and it becomes a large burden on the cost reduction of the photovoltaic power generation.

In order to solve such a problem, it is proposed to use a technology for forming a silicon thin film through epitaxial growth (see Japanese Patent No. 3007971, International publication No. WO2005/069356, Japanese Patent Application Laid-Open No. 6-20945, Japanese Patent Application Laid-Open No. 4-199749, Japanese Patent Application National Publication (Laid-Open) No. 2009-505938, Applied Physics, Vol.76 No. 6, 619, 2007, "Phenomenon and Prospects of Silicon-Based Photovoltaic Cell", written by Michio Kondo, Research Center for Photovoltaics, National Institute of Advanced Industrial Science and Technology, and "MOS Device Epitaxial Wafer, Chapter 2, Section 1: Epitaxial Seicho Gijutsu (Epitaxial Growth Technology) ", Realize Inc.) and use the acquired silicon that is in a thin-film state as the material of the photovoltaic cell. At this time, the silicon thin film is formed on a silicon substrate, and thus peeling-off thereof is necessary after the formation.

In Japanese Patent Application Laid-Open No. 2002-217438, a technology is disclosed in which a silicon thin film is epitaxially grown on a silicon substrate, and stress is applied to the substrate after the growth, whereby the silicon thin film is peeled off from the substrate. However, according to this technology, since the stress is also applied to the silicon thin film, the stress may be easily concentrated at a specific position of the silicon thin film, and there is a concern that a crack or fracture is generated at the concentrated position, whereby the technology is not appropriate for forming a silicon thin film having a large area.

Thus, a technology is considered in which, by applying a technology of selecting and growing gallium nitride on a sapphire substrate as illustrated in Japanese Patent Application Laid-Open No. 2004-55799 to silicon, stress applied to a silicon thin film at the time of peeling-off is suppressed by decreasing a bonding area between a silicon substrate and the silicon thin film, whereby mechanical peeling-off can be easily performed.

In U.S. Patent No. 4,578,142, a technology is disclosed in which a silicon thin film is formed on a silicon substrate by selectively forming a silicon oxide film on the silicon substrate, growing a silicon single crystal in an exposed area of the silicon substrate, growing the silicon single crystal on the silicon oxide film in the horizontal direction, and covering the surface of the silicon oxide film with the silicon single crystal thin film.

In Japanese Patent Application Laid-Open No. 6-20945, a technology is disclosed in which a silicon thin film is formed on a silicon substrate by selectively forming a silicon oxide film on the silicon substrate, growing a silicon single crystal in an exposed area of the silicon substrate, growing the silicon single crystal on the silicon oxide film in the horizontal direction, and covering the silicon single crystal thin film. In Japanese Patent Application Laid-Open No. 6-20945, the object is to separate the silicon oxide film as an insulating film and the silicon thin film after growth from each other. First, the silicon oxide film as an insulating film is formed on the silicon substrate through thermal oxidation, the silicon substrate is coated with a photoresist agent acquired by mixing silica powders having a particle diameter of 1 µm, and then, a slit-shaped exposed area is arranged on the silicon substrate by using a general photolithographic technology. Then, by cleaning the silicon substrate using acetone, the photoresist is eliminated from the powder particles so as to allow the silica powers to remain on the silicon oxide film, and thereafter, a silicon thin film is formed on the silicon substrate by using a selective growth method. These silica powders weaken the bonding force between the silicon substrate and the silicon thin film after growth, whereby the peeling-off from the silicon oxide film can be performed.

In addition, also in Japanese Patent Application Laid-Open No. 4-199749, a technology is disclosed in which a silicon thin film is formed on a silicon substrate by covering the thin film on the silicon single crystal according to the same method. Japanese Patent Application Laid-Open No. 4-199749 discloses a method of peeling off the silicon thin film by avoiding bonding between the thermally-oxidized film and the silicon thin film, in order to avoid bonding between the thermally-oxidized film formed on the substrate and the silicon thin film after growth, epitaxial growth is stopped before the entire surface is covered by the growth of the silicon thin film according to the selective growth method, a non-growing hole is allowed to intentionally remain on the thermally-oxidized film, thereafter, hydrofluoric acid is injected through the non-growth hole, and the thermally-oxidized film is removed before peeling-off of the silicon thin film.

Furthermore, in Japanese Patent Application National Publication (Laid-Open) No. 2009-505938, a method is disclosed in which a thin film is formed on a substrate by selecting different materials for the substrate and the thin film to be formed, although the thin film is formed on the substrate by using the same method, the substrate and the growing thin film are composed with different materials, and peeling off is performed by using thermal stress generated based on a temperature difference in the process of cooling using a difference between thermal expansion coefficients of the materials forming the substrate and the growing thin film.

However, in U.S. Patent No. 4,578,142, as the material of the silicon thin film, gas having high vapor-phase reactivity such as monosilane (SiH₄) or dichlorosilane (SiH₂Cl₂) is used, and accordingly, HCl gas preventing multi-crystallization is used. A silicon wafer in which a silicon thin film is formed on the silicon substrate according to U.S. Patent No. 4, 578, 142 is used for an IC or an monolithic semiconductor, and accordingly, not only the silicon thin film but also the oxide film is used, whereby the peeling-off of the silicon oxide film from the silicon substrate is avoided. In addition, as physical properties of the oxide film, an electric insulating property and thermal conductivity are required.

Accordingly, the silicon oxide film used in U.S. Patent No. 4,578,142 is formed to have the physical properties of the electric insulating property and the thermal conductivity and is a thermally-oxidized film that is formed by selecting a high-temperature region for avoiding the peeling-off. Since this aims for strong bonding with the silicon substrate, as a result, it is difficult to peel off the silicon thin film from the silicon substrate.

On the other hand, according to the methods disclosed in Japanese Patent Application Laid-Open Nos. 6-20945 and 4-199749, and Japanese Patent Application National Publication (Laid-Open) No. 2009-505938, the silicon thin film can be peeled off from the silicon substrate in principle. However, according to the methods disclosed in Japanese Patent Application Laid-Open Nos. 6-20945 and 4-199749, it is necessary that a supporting substrate be attached to the silicon thin film at the time of peeling-off, and the silicon thin film is peeled off from the silicon substrate at once. Accordingly, the peeling-off process is complicated, a strong external force is necessary at the time of peeling-off, and the external force needs to be uniformly applied to the entire face, whereby the cost is incurred, and it is difficult to peel off a large-area silicon thin film.

In addition, according to Japanese Patent Application Laid-Open Nos. 6-20945 and 4-199749, as a plan for decreasing the strong external force needed for the peeling-off as much as possible, a method is used in which the width of the insulating layer is configured to be large, and the pitch of the silicon crystals that are directly grown on the silicon substrate is configured to be large (in examples of both documents, 50 µm). However, accordingly, there is a problem in that the variation of the thickness of the growing thin film necessarily increases.

Furthermore, according to the method disclosed in Japanese Patent Application Laid-Open No. 6-20945, there is a concern that silica is mixed into the silicon thin film that is used for single-crystal growth, and there is a problem in that the yield ratio of manufacturing the silicon thin film decreases. In addition, according to the method disclosed in Japanese Patent Application Laid-Open No. 4-199749, the non-growth hole used for introducing hydrofluoric acid remains in the silicon thin film after growth. Accordingly, for example, in a case where the silicon thin film is used as a material of a photovoltaic cell, since electrodes are formed on both faces, in order to avoid formation of a short circuit between the electrodes formed on both faces, stuffing the non-growth hole is necessary, whereby there is a problem in that additional cost is incurred.

In addition, in the method disclosed in Japanese Patent Application National Publication (Laid-Open) No. 2009-505938, since the thin film is peeled off from the substrate based on a difference between the thermal expansion coefficients of the substrate and the thin film, a crack may be generated in the thin film due to thermal stress accompanied with a change in temperature. Particularly, such a phenomenon becomes more prominent as the area is large, and it is difficult to peel off a large area.

Thus, in consideration of the above-described problems, the object of the invention is to provide, utilizing nano properties of silicon that are disclosed in recent researches on the physical properties (Nano Letters, 2006. Vol. 6, No. 4, 622-625 Samuel Hoffmann et, al; Measurement of the Bending Strength of Vapor-Liquid-Solid Grown Silicon Nanowires and Namazu, T. et al; Microelectromech. Syst. 2000, .9, 450 Evaluation of Size Effect on Mechanical Properties of Single Crystal Silicon by Nanoscale Bending Test Using AFM), in other words, a physical property that silicon grows in proportion to an external force before breaking in a case where the width size of the silicon crystal is 1 µm or less, a method of manufacturing a silicon thin film that can be peeled off from the silicon substrate by a small force without damaging the large area silicon thin film, which is a silicon thin film grown on the silicon substrate, a method of manufacturing a silicon thin-film photovoltaic cell using the above-described silicon thin film, and the silicon thin film and the silicon thin-film photovoltaic cell that are manufactured by using the above-described manufacturing methods.

### SUMMARY OF THE INVENTION

To achieve the above-mentioned problems, in a first aspect of the invention, in the method of manufacturing a silicon thin film, an inert face formed by an exposed face of a silicon substrate and an inert layer is formed by selectively forming the inert layer on the silicon substrate in which growth of a silicon crystal is inactive for a raw material gas of the silicon crystal, and the silicon crystal is grown from the exposed face such that the silicon crystal covers the silicon substrate by supplying a raw material gas, of which a surface decomposition reaction on the silicon substrate is dominant, out of the raw material gas to the silicon substrate, and in which, by forming a width of the exposed face in a range of 0.001 µm to 1 µm, while the silicon crystal formed on the exposed face is extended and peeled off, the silicon thin film is formed in a state that the silicon thin film can be peeled off from the silicon substrate.

According to the above-described method, in order to enable static sequential peeling-off of the silicon thin film (sequential peeling-off naturally or by a weak force), the exposed face that promotes the growth is arranged with a width in the range of 0. 001 µm to 1 µm in which extensibility according to the nano properties of silicon is represented, and a silicon crystal that becomes the core of growth of the silicon thin film and enables the static sequential peeling-off is grown at the exposed face. The silicon crystal (silicon pillar) having the nano properties has mechanical characteristics quite different from those of general bulk silicon and has a quite different peeling-off mechanism. In other words, when the silicon thin film grown on the substrate is peeled off by applying an external force pulling the silicon thin film away from the substrate starting from the end portion of the silicon thin film, nano silicon of the silicon pillar portion, which is located at the exposed face and is grown on the endmost side, having the nano characteristics starts to grow, as the external force increases, the nano silicon further grows, and the silicon pillar portion of the next stage starts to grow in a wire shape on the inner side of the end portion, and then, finally, the forefront wire reaches partial peeling-off. Then, the position of the wire (silicon pillar) of the next stage is changed to the forefront position, and the wire finally reaches partial peeling-off. By continuing such repetitions, the static sequential peeling-off progresses for the entire face of the substrate. According to this method, in the peeling-off process, stress is concentrated only on very limited nano silicon of nano silicon located at the forefront and nano silicon located on the next stage and nano silicon located on the next stage after the above-described next stage. Accordingly, since the static sequential peeling-off can be performed sequentially from the end, a silicon thin film having a large area can be formed without applying a large external force thereto.

In a second aspect of the invention, in the method, an etching agent that etches the inert layer is supplied to an end portion, which is to be peeled off, of the silicon thin film.

According to the above-described method, the promotion of peeling-off between the inert face and the silicon thin film and the removal of the inert layer attached to the silicon thin film can be simultaneously performed. Particularly, in a case where a material such as a thermally-oxidized film that has strong bonding force for the silicon thin film is formed as the inert layer, a prominent advantage can be acquired.

In a third aspect of the invention, in the method, the inert layer is formed of a material having breaking strength lower than that of the silicon thin film.

In a case where a material having breaking strength lower than that of the silicon thin film, for example, a natural oxide film is used for forming the inert layer, a bonding force between atoms is weak in the natural oxide film, and accordingly, the inert layer can be easily broken. Accordingly, the inert layer can be broken without damaging the silicon thin film, or an interface between the inert layer and the silicon substrate or an interface between the inert layer and the silicon thin film can be broken, whereby the silicon thin film can be easily peeled off from the silicon substrate.

In a fourth aspect of the invention, in the method, the inert layer is formed by an oxide film, and the oxide film is formed in an oxygen-rich state.

According to the above-described method, since oxygen is supplied to the silicon crystal that is grown at the exposed face from the periphery thereof, the periphery of the silicon crystal is oxidized, and a bonding strength between the oxidized portion and the silicon crystal remaining without being oxidized decreases. Accordingly, the extensibility of the silicon crystal remaining without being oxidized is improved, and therefore the stress at the time of peeling-off can be decreased. Furthermore, in a case where the silicon crystal grown at the exposed face is completed oxidized by the oxygen supplied from the periphery, the silicon thin film is in a state of being formed on an oxide film, and accordingly, the silicon thin film can be easily peeled off.

In a fifth aspect of the invention, in the method, after the silicon thin film is grown, a heat treatment is performed for the oxide film and the silicon thin film.

According to the above-described method, the oxidation of the silicon crystal grown at the exposed face is promoted, whereby the silicon thin film can be easily peeled off.

In a sixth aspect of the invention, in the method, the width of the exposed face is formed so as to be 0.45 µm or less, and a thickness of the silicon thin film is grown until the thickness becomes any specific thickness up to 40 µm.

The thickness of the silicon thin film used for a photovoltaic cell needs to be 30 µm. The inventors of the invention have found that, by configuring the width of the exposed face to be 0.4 µm or less, the silicon crystal formed on the exposed face is oxidized in accordance with the growth of the silicon thin film, and the covalent bonding between the silicon thin film and the silicon substrate is broken. Similarly, in a case where the thickness of the silicon thin film is configured to be 40 µm, the inventors have found that, when the width of the exposed face is configured to be 0.45 µm or less, the silicon pillar is oxidized up to the center axis. Accordingly, by configuring as above, the silicon thin film can be easily peeled off from the silicon substrate without using an external force.

In the seventh aspect of the invention, in the method, the material that forms the inert layer is doped with a P-type or N-type dopant.

According to the above-described method, a portion of the silicon thin film that is in contact with the inert layer is doped with a dopant, whereby an electrode layer can be formed. Therefore, a separate process of forming the electrode layer is not necessary, whereby the cost can be suppressed.

In the eighth aspect of the invention, in the method, the silicon substrate is formed in a curved shape, and the inert layer and the silicon crystal are formed on a surface of the curved shape of the silicon substrate.

According to the above-described method, the silicon thin film can be formed in accordance with the shape of the mounting destination.

In the ninth aspect of the invention, in the method, the raw material gas is doped with a P-type or N-type dopant, and the dopant is switched between the P-type and the N-type during formation of the silicon thin film.

According to the above-described method, a PN junction can be formed in the thickness direction of the silicon thin film.

In a tenth aspect of the invention, in the method, the exposed face on which the inert face and the silicon thin film are exposed is formed on the silicon thin film, and a new silicon thin film is formed on the silicon thin film. According to the above-described method, a silicon thin film having a multi-layer structure can be formed from one sheet of the silicon substrate, and therefore, the silicon thin films can be produced in a large scale.

In a eleventh aspect of the invention, in the method, on at least one side of a peripheral edge area of the silicon substrate, an area ratio of the inert face to the exposed face is higher than that in a center area of the silicon substrate.

According to the above-described method, by dominantly forming the inert face at least on one side of the peripheral edge area of the silicon substrate, a peeling-off tab can be formed in the peripheral edge area of the silicon thin film. Accordingly, the silicon thin film can be easily peeled off from the silicon substrate by using the peeling-off tab as a starting point, whereby the yield ratio of the silicon thin film can be raised.

In a twelfth aspect of the invention, in the method, electrodes are formed on both faces of the silicon thin film that is formed according to any one of claims 1 to 11.

According to the above-described method, a thin film photovoltaic cell having a large area can be manufactured while suppressing the cost thereof.

In a thirteen aspect of the invention, in a silicon thin film that is formed by a silicon crystal and has a plurality of convex portions arranged on a principal face thereof, the convex portions have a width in the range of 0.001 µm to 0.8 µm and have peeling-off marks that are formed in a form of tearing off the silicon crystal and/or etching marks that are formed in a form acquired by removing a silicon oxide film formed on tip ends of the convex portions through etching at the tip ends of the convex portions.

According to the above-described configuration, the convex portion can be formed by forming a silicon pillar on the exposed face formed together with the inert face on the above-described silicon substrate, and the silicon thin film can be formed by growing the silicon crystal in the horizontal direction by using the silicon pillar formed on the exposed face as a core. By configuring the size of the exposed face to be the above-described size, the silicon pillar formed on the exposed face is formed as nano silicon from the exposed face. Accordingly, by applying stress to the silicon thin film, the silicon pillar extends and is peeled off from the silicon substrate, whereby a peeling-off mark is formed at the tip end of the convex portion.

In addition, in a case where the silicon thin film is peeled off from the silicon substrate, the stress is concentrated only on very limited silicon pillars of the silicon pillar located at the forefront and the silicon pillars of the next stage and a stage next to the above-described next stage.

In addition, as described above, in a case where the silicon pillar is oxidized in accordance with the growth of the silicon thin film, the silicon pillar that has been oxidized is etched by hydrofluoric acid or the like, and accordingly, at the front end of the convex portion, an etching mark (a concavo-convex shape of the interface between the silicon thin film and the oxidized silicon pillar) is formed.

Accordingly, in any case, since static peeling-off can be sequentially performed from the end, a silicon thin film can be formed so as to have a large area without applying a strong external force.

In a fourteenth aspect of the invention, in the silicon thin film, a thickness of the silicon thin film is 40 µm or less, the width of the convex portion is 0.45 µm or less, and the etching mark is included at the tip end of the convex portion.

The thickness of the silicon thin film used for a photovoltaic cell needs to be 30 µm. The inventors of the invention have found that, by configuring the width of the exposed face to be 0.4 µm or less, the silicon crystal formed on the exposed face is oxidized up to the central axis in accordance with the growth of the silicon thin film, and the covalent bonding between the silicon thin film and the silicon substrate is broken. Similarly, in a case where the thickness of the silicon thin film is configured to be 40 µm, the inventors have found that, when the width of the exposed face is configured to be 0.45 µm or less, the silicon pillar is oxidized up to the center axis. In such a case, since the silicon pillar is oxidized up to the central axis, an etching mark is formed at the tip end of the above-described convex portion. Accordingly, by configuring as above, the silicon thin film that can be easily peeled off from the silicon substrate without using an external force is formed.

In a fifteenth aspect of the invention, a thin-film photovoltaic cell that is formed by forming electrodes on both faces of the silicon thin film.

Accordingly, a thin film photovoltaic cell having a large area can be formed while suppressing the cost.

According to a method of manufacturing a silicon thin film, a method of manufacturing a thin film photovoltaic cell, and a silicon thin film according to the invention, by utilizing the extensibility of nano silicon, static sequential peeling-off can be performed in which peeling-off is started from one end of the silicon thin film, and gradually, the peeling-off reaches the entire face, and ultimately, peeling-off without using an external force can be also performed.

In addition, according to the invention, since the above-described silicon thin film is formed by peeling off the silicon thin film from the silicon substrate, the loss of the silicon material is avoided, and the silicon substrate after the peeling-off of the silicon thin film can be reused, whereby a silicon thin film of which the cost is suppressed and a thin film photovoltaic cell in which electrodes are formed on the silicon thin film can be manufactured.

### BRIEF DESCRIPTION OF THE DRAWINGS

FIG. 1 is a layout diagram for manufacturing a silicon thin film according to a first embodiment through epitaxial growth;
FIG. 2 is a schematic diagram of a silicon substrate used for manufacturing a silicon thin film according to the first embodiment;
FIG. 3 is a schematic diagram illustrating a growth step (initial step) of a silicon crystal according to the first embodiment;
FIG. 4 is a schematic diagram illustrating the growth step (an initial phase of a horizontal growth step) of the silicon crystal according to the first embodiment;
FIG. 5 is a schematic diagram illustrating the growth step (a later phase of the horizontal growth step) of the silicon crystal according to the first embodiment;
FIG. 6 is a schematic diagram illustrating the growth step (a final step) of the silicon crystal according to the first embodiment;
FIG. 7 is a schematic diagram illustrating the appearance of peeling off the silicon thin film according to the first embodiment from the silicon substrate;
FIG. 8 is a schematic diagram illustrating the silicon thin film after peeling it off;
FIG. 9 is a schematic diagram illustrating an initial process according to a method of manufacturing a silicon thin film of a third embodiment;
FIG. 10 is a schematic diagram illustrating a selective growth process according to the method of manufacturing a silicon thin film of the third embodiment;
FIG. 11 is a schematic diagram illustrating a thin-film forming process according to the method of manufacturing a silicon thin film of the third embodiment;
FIG. 12 is a schematic diagram illustrating the silicon thin film after peeling-off according to the third embodiment;
FIG. 13 is a schematic diagram illustrating a method of manufacturing a silicon thin film according to an eight embodiment;
FIG. 14 is a table illustrating the thickness of an oxide film formed in a silicon pillar in a case where a plurality of widths of an inert layer is set, and a silicon thin film is grown until the completion of horizontal growth; and
FIG. 15 is a table illustrating the thickness of an oxide film formed in a silicon pillar in a case where a plurality of growth speeds and a plurality of thicknesses of a silicon thin film to be formed are set, and the silicon thin film is grown up to a predetermined thickness after horizontal growth.

### DESCRIPTION OF THE PREFERRED EMBODIMENTS

Hereinafter, embodiments of the invention will be described with reference to the accompanying drawings. However, the constituent elements, types, combinations, shapes, relative arrangements, and the like described in the embodiments are not for the purpose of limiting the scope of the invention thereto unless otherwise mentioned, but merely descriptive examples.

A layout for manufacturing a silicon thin film according to this embodiment through epitaxial growth is illustrated in FIG. 1. As illustrated in FIG. 1, a silicon substrate 32 is installed on an installation base 24 disposed inside an epitaxial growth reactor 18 as a vacuum chamber, and the silicon substrate 32 is heated up to a predetermined temperature by a heater 26 that is arranged on the outside of the epitaxial growth reactor 18. Raw material gas 28 is introduced from a row gas inlet 20 of the epitaxial growth reactor 18 and is chemically reacted on the surface of the silicon substrate 32, and the silicon crystal 12 is epitaxially grown, whereby a silicon thin film 10 is formed with the silicon crystal 12 on the silicon substrate 32. Then, surplus raw material gas 28 is discharged from a raw gas outlet 22 of the epitaxial growth reactor 18.

In such a layout, according to a method of manufacturing the silicon thin film 10 according to the first embodiment, an inert face 36 is formed by the exposed face 34 of the silicon substrate 32 and an inert layer 38 by selectively forming the inert layer 38 in which the growth of the silicon crystal 12 is inactive for the raw material gas 28 of the silicon crystal 12 on the silicon substrate 32, and the silicon crystal 12 is grown from the exposed face 34 by supplying raw material gas 28, of which a surface decomposition reaction is dominant on the silicon substrate 32, out of the above-described raw material gas 28 to the silicon substrate 32, whereby the silicon thin film 10 is manufactured in a form in which the silicon crystal 12 covers the silicon substrate 32. Particularly, by forming the width of the exposed face 34 in the range of 0.001 µm to 1 µm, the silicon thin film 10 is formed in a state that the silicon thin film 10 can be peeled off from the silicon substrate 32. In this embodiment, since the exposed face 34 is formed so as to have the above-described dimensions, silicon pillars 12a (nano silicon, see FIG. 3) are formed horizontally and vertically in areas surrounded by the inert layer 38 on the exposed face 34.

Hereinafter, the properties of the nano silicon that is used in this embodiment will be described. The breaking strength of silicon in compression is in the range of 4900 Kgrs/cm² to 5600 Kgrs/cm². This value is a numeric value in the case of compression and is a value of bulk silicon before the breaking strength of the nano silicon in compression is known (an unknown document).

According to recent through researches, it has been reported that, when the external dimension of silicon is decreased to be in a nano-scale, the mechanical properties thereof dramatically change so as to represent an extraordinarily strong bending or tensile property in nano silicon. According to Nano Letters, 2006. Vol. 6, No. 4, 622-625 Samuel Hoffmann et, al; Measurement of the Bending Strength of Vapor-Liquid-Solid Grown Silicon Nanowires as a non-patent document, it is reported that the ability to endure bending of nano silicon is 12 Giga Pascal based on a bending test of nano silicon. In addition, in Nano Letters, 2006. Vol. 6, No. 4, 622-625 Samuel Hoffmann et, al; Measurement of the Bending Strength of Vapor-Liquid-Solid Grown Silicon Nanowires, it is reported that there is no change (186 Giga Pascal) in the Young's modulus between bulk silicon and nano silicon, and accordingly, the nano silicon is broken after representing extensibility that is 21 to 24 times as high as the extensibility of bulk silicon (based on the above-described breaking strength of bulk silicon) in accordance with the Hooke' s law. However, this represents that the breaking strength increases at the same rate, and accordingly, it is understood that the silicon thin film is difficult to peel off from the silicon substrate. However, instead of peeling off the silicon thin film at once by applying stress to all the silicon pillars after the thin film is reinforced by using a reinforcing plate as in Japanese Patent Application Laid-Open Nos. 6-20945 and No. 4-199749, sequential partial peeling-off, to be described later, can be realized in which silicon pillars 12a are peeled off one after another by sequentially applying stress to the silicon pillars 12a, and accordingly, the silicon thin film 10 can be peeled off from the silicon substrate 32 by using a small force. As above, it is difficult to perform sequential partial peeling-off of the nano silicon in a case where the nano silicon does not have high extensibility.

In Namazu, T. et al; Microelectromech. Syst. 2000, 9, 450 Evaluation of Size Effect on Mechanical Properties of Single Crystal Silicon by Nanoscale Bending Test Using AFM as a non-patent document, a research on the bending strength of silicon has been made, and by using test materials of 200 nm to 800 nm, it becomes apparent in terms of numeric vales that the physical properties largely change as the dimension of the silicon decreases from millimeter to micrometer and from micrometer to nanometer. The range of the width (a length of one side) of the silicon pillar 12a, which has nano properties, employed in this embodiment is limited to the range, in which the nano properties are represented, represented in this document.

In other words, in Namazu, T. et al; Microelectromech. Syst. 2000, 9, 450 Evaluation of Size Effect on Mechanical Properties of Single Crystal Silicon by Nanoscale Bending Test Using AFM, in order to determine the starting point (the inside, the surface, or the edge of the crystal) of breaking of the silicon crystal, the nano properties are checked for an effective length of 1 µm or less by summarizing experimental results by citing "the risk of rupture theory" written by Davies (FIG. 10 illustrated in Page No. 455 and 18th line from the bottom of the left column in Page No. 456 of Namazu, T. et al; Microelectromech. Syst. 2000, 9, 450 Evaluation of Size Effect on Mechanical Properties of Single Crystal Silicon by Nanoscale Bending Test Using AFM).

In addition, in Namazu, T. et al; Microelectromech. Syst. 2000, 9, 450 Evaluation of Size Effect on Mechanical Properties of Single Crystal Silicon by Nanoscale Bending Test Using AFM, the starting points of the breaking of the silicon crystal in a two dimension and a three dimension are mentioned, and the changes in the nano properties are checked. In this embodiment, although the width of the exposed face 34, that is, the width of the silicon crystal is in the range of 0.001 µm to 1 µm, by appropriately selecting the two-dimensional size (the widths and the depths of the exposed face 34 and the silicon pillar 12a) and the three-dimensional size (the width, the depth, and the length of the silicon pillar 12a), it can be checked based on data illustrated in Namazu, T. et al; Microelectromech. Syst. 2000, 9, 450 Evaluation of Size Effect on Mechanical Properties of Single Crystal Silicon by Nanoscale Bending Test Using AFM that static sequential peeling-off can be performed.

Accordingly, in this embodiment, by configuring the width (or one side) of the exposed face 34 to be 1 µm or less, in an area that has the exposed face 34 as the bottom face and is surrounded by the side faces of the inert layer 38, a cross-section of the same size as that of the exposed face 34, which is formed so as to bury the area, is included, whereby silicon pillars 12a having properties as nano silicon are grown.

Here, a case will be considered in which a silicon thin film according to this embodiment, in which a pitch Wa of 1 µm and a pitch Wb of 10 µm are assumed, is formed on a rectangular wafer (silicon substrate) of 30 cm, and the silicon thin film is peeled off from the periphery of the rectangular wafer. Then, about 30, 000 silicon pillars (having a wire shape), which has a one-side length of 1 µm, bonded to the silicon substrate in a linear shape extend in a length of 30 cm.

Here, the inventors of the present application have found that a force of 1.2 g is necessary for peeling each one of the silicon pillars 12a each having a width of 1 µm in a case where the above-described breaking strength and the above-described extensibility are considered. Accordingly, a force necessary for slowly peeling off the thin film having a one side length of 30 cm is a value is calculated as about 36 kg by using the values of the above-described breaking strength of silicon, and this value is a value that is necessary for static peeling-off. Actually, as in a second embodiment to be described later, when a peeling-off force from the inert layer 38 and the like are considered, a tensile force that is about twice the value is applied to the silicon thin film 10, and accordingly, in a case where the pitch Wa is longer than the above-described value, it is difficult to practically perform the static sequential peeling-off. However, in a third embodiment to be described later, in a case where the silicon pillars 12a are completed oxidized, such a consideration is not necessary.

Accordingly, in this embodiment and all the other embodiments to be described later, the upper limit of the pitch Wa is considered to be 1 µm as an appropriate value based on the use of the nano properties (Japanese Patent Application Zaid-Open No. 2004-55799) represented in a case where the width size (corresponding to the diameter) of the silicon pillar is 1 µm or less and the external force necessary for peeling off the large-area thin film as described above. Although it is advantageous for peeling-off as the pitch Wa decreases, when the pitch Wa is 0.001 µm, a length is formed for which several silicon atoms are exposed, and it is considered that it is difficult to perform normal epitaxial growth for an exposed face that has a pitch Wa of 0.001 µm or less.

The simplification of peeling-off of the silicon thin film 10 that is formed as a film is influenced by an area ratio between the exposed face 34 and the inert face 36. In a case where the area ratio of the inert face 36 to the exposed face 34 is high, although the silicon thin film 10 can be easily peeled off, it takes long time to grow the silicon crystal 12 on the inert face 36 in the horizontal direction, which is economically disadvantageous. In contrast to this, in order to shorten the time required for growing the silicon crystal 12 on the inert face 36 in the horizontal direction, it is effective that the pitches Wa and Wb of the exposed face 34 and the inert face 36 that are formed on the entire face of the silicon substrate 32 are small.

The silicon pillars 12a (silicon crystal 12) grown at the exposed face 34 (the pitch Wa) grow in the horizontal direction on the inert face 36 (the pitch Wb) so as to be connected on the inert face 36, thereby forming a silicon thin film 10. At that time, the film thickness on the inert face 36 is less than the film thickness on the exposed face 34. In addition, it is considered that the film thickness of a portion that is finally connected on the inert face 36 is much smaller. Although the thin film thickness of the silicon thin film 10 is assumed to be 30 µm in this embodiment, for example, in a case where the pitches Wa and Wb are configured to be 1 µm and 10 µm, respectively, when a portion of the pitch Wa is grown to have a thickness of 30 µm, the lowest value of the film thickness of a portion located on the inert layer 38 (the pitch Wb) is calculated as 25 µm (variation 17%) as will be described later. The variation (17%) of the thickness is considered as a practical upper limit on a large scale.

The variation of the thickness is determined by the value of the inert face 36 (the pitch Wb). As the time required for the silicon pillars 12a to grow in the horizontal direction on the inert face 36 (the pitch Wb) and be finally connected increases, the variation increases, and accordingly, it can be determined as a practical upper limit to configure the pitch Wb as 10 µm as described above. In Japanese Patent Application Laid-Open No. 6-20945 and Japanese Patent Application Laid-Open No. 4-199749, the pitch Wb is configured as 50 µm. In such a case, in a case where a thin film of 30 µm is to be formed, the lowest value of the portion of the pitch Wb is calculated as 5 µm (a thickness variation of 83%), and accordingly, the variation is too high to be appropriate for a practical use.

On the other hand, as a countermeasure used for decreasing the variation of the thickness, the pitch Wb may be decreased. Thus, in order to decrease the variation of the thickness, in a case where the pitch Wb is changed from 10 µm to 1 µm, the pitch Wa is 1 µm, and accordingly, the ratio Wb/Wa is one, and the variation of the thickness at this time is improved as 1.7%. However, as the value of the inert face 36 (the pitch Wb) decreases, the ratio of the exposed face 34 (the pitch Wa) increases, which is disadvantageous as the peeling-off face of the silicon thin film 10.

Accordingly, the pitches Wa and Wb are practically selected in consideration of a balance between them. As one solution, in a case where the pitch Wa is changed to 0.1 µm, the ratio Wb/Wa is 10, and accordingly, the variation of the thickness is maintained to be 1.7%, whereby the condition of the peeling-off can be improved. In addition, as another solution, in a case where the pitch Wa is configured to be 0.01 µm while maintaining the pitch Wb to be 1 µm, the ratio Wb/Wa is 100, and accordingly, the condition of the peeling-off can be improved much while maintaining the variation of the thickness to 1.7%.

As above, regarding the sizes (the width or the one side length) of the exposed face 34 (the pitch Wa) and the inert face 36 (Wb), it can be concluded that the pitch Wa is preferably to be in the range of 0. 001 µm to 1 µm within the range in which the pitch Wa represents the nano properties of the silicon pillar from the practical viewpoint, and the pitch Wb is preferably larger than the pitch Wa and is 10 µm or less in correspondence with the pitch Wa.

FIG. 2 illustrates a silicon substrate used for manufacturing a silicon thin film according to the first embodiment. As the silicon substrate 32, a substrate that has a surface (100) on which the silicon thin film 10 is grown as silicon multi-crystal or silicon single-crystal as a face or the like is used. As above, by configuring the material of the substrate on which the silicon thin film 10 is grown to be the same as that of the silicon thin film 10, the generation of lattice distortion for the silicon thin film 10 is suppressed, whereby a high-quality silicon thin film 10 can be formed.

While the object of this embodiment (similarly, the objects of the other embodiments described below) is to peel off the silicon thin film 10 after epitaxial growth from the silicon substrate 32, in order to achieve the object, it is necessary to alternately form both faces including the exposed face 34 of the silicon substrate 32 that is active for the raw material gas 28 and the inert face 36 that is covered with the inert layer 38 formed from an oxide film on the surface of the silicon substrate 32 that is provided for the epitaxial growth in advance and to provide the both faces for the epitaxial growth.

Thus, on the surface of the silicon substrate 32, the inert layer 38 that is inactive for crystal growth using the raw material gas 28 and an oxide film (SiO₂) used for forming the inert face 36 (mask face) on the surface are formed by being patterned. In addition, in this embodiment, a thermally-oxidized film is used as the inert layer 38.

As the thermally-oxidized film, it is possible to use an oxide film that is grown by allowing wet oxygen (95°C H₂O) to flow on the surface of the silicon substrate 32 at high temperature (for example, 1000°C). The patterning of the thermally-oxidized film is formed by forming a resist film (not illustrated in the figure) on the surface of the silicon substrate 32 and then exposing the resist film, removing a portion in which the thermally-oxidized film is exposed through etching using hydrofluoric acid or the like, and then removing the resist film (not illustrated in the figure).

Since the silicon thin film 10 is grown on the silicon substrate 32 on which the thermally-oxidized film is formed as above, the raw material gas 28 is supplied to the silicon substrate 32. The raw material gas 28 is acquired by allowing a silicon compound as the material of the silicon crystal 12 to be contained in carrier gas such as hydrogen at a predetermined ratio and is supplied to the epitaxial growth reactor 18 at predetermined temperature or predetermined flow rate. As examples of the raw material gas 28 that is used for the epitaxial growth, there are monosilane (SiH₄), dichlorosilane (SiH₂Cl₂), trichlorosilane (SiHCl₃), silicon tetrachloride (SiCl₄), and the like. When such gas is used, it is appropriately diluted with hydrogen.

In a vapor-phase epitaxial growing mechanism, a transport phenomenon and chemical reactions (a vapor phase decomposition reaction and a surface decomposition reaction) of the raw material gas 28 are accompanied. Particularly, at high temperature at which epitaxial growth is performed, although the vapor-phase decomposition reaction and the surface decomposition reaction need to be considered as rate controlling reactions, in this embodiment, gas for which the ratio of the vapor-phase decomposition reaction is extremely smaller than that of the surface decomposition reaction and the surface decomposition reaction is dominant needs to be selected. Accordingly, among the above-described raw material gas 28, the monosilane (SiH₄) is not appropriate due to its high ratio of vapor-phase decomposition but chlorine-based gas such as trichlorosilane (SiHCl₃) is appropriate. Accordingly, the silicon crystal 12 is suppressed from being directly deposited on the inert face 36 that is formed as an oxide film, whereby the inert face 36 can be covered by horizontal growth of the silicon crystal 12 (silicon pillar 12a) grown from the exposed face 34.

Here, in this embodiment, although a thermally-oxidized film that is formed at high temperature is used as the inert layer 38, the thermally-oxidized film may be a mechanically firm material and be strongly bonded to the silicon thin film 10. Accordingly, as in this embodiment, in a case where the silicon thin film 10 is peeled off from the thermally-oxidized film, there is a little disadvantage. However, according to the first embodiment, as will be described later, the thermally-oxidized film is etched by using an etching solution such as hydrofluoric acid, and accordingly, the thermally-oxidized film does not block the peeling-off of the silicon thin film 10.

FIG. 3 illustrates a growth step (initial step) of a silicon crystal according to the first embodiment, FIG. 4 illustrates the growth step (an initial phase of a horizontal growth step) of the silicon crystal according to the first embodiment, FIG. 5 illustrates the growth step (a later phase of the horizontal growth step) of the silicon crystal according to the first embodiment, FIG. 6 illustrates the growth step (a final step) of the silicon crystal according to the first embodiment, and FIG. 7 illustrates the appearance of peeling off the silicon thin film according to the first embodiment from the silicon substrate.

First, as illustrated in FIGS. 1 and 2, the silicon substrate 32 used for growing the silicon thin film 10 is installed to the installation base 24 inside the epitaxial growth reactor 18. At this time, the patterning according to the exposed face 34 of the silicon substrate 32 and the inert face 36 formed as a thermally-oxidized film is formed in advance. Then, the temperature is raised up to temperature that is necessary for the epitaxial growth of the silicon thin film 10 on the silicon substrate 32, and the raw material gas 28 of predetermined temperature is supplied to the silicon substrate 32 at a predetermined flow rate. Generally, hydrogen chloride (HCl) gas is mixed into the raw material gas 28 so as to precipitate selective growth.

Next, as illustrated in FIG. 3, at relatively low temperature (for example, temperature in the range of 600°C to 1000°C) of the initial phase of the epitaxial growth, a surface reaction of the raw material gas 28 occurs at the exposed face 34 of the silicon substrate 32, whereby the growth of the silicon pillars 12a (silicon crystal 12) is started. However, the raw material gas 28 selected as above is suppressed from surface reacting in an area located on the inert face 36 formed by the thermally-oxidized film, and decomposition is not started. Then, the silicon pillars 12a grown from the exposed face 34 are epitaxially grown as nano silicon.

Then, as illustrated in FIG. 4, when the epitaxial growth advances, and the silicon crystal 12 (the silicon pillars 12a) grown at the exposed face 34 is grown up to the thickness of the inert layer 38 that forms the inert face 36, thereafter, the silicon crystal 12 starts to be grown in the horizontal direction also on the inert face 36. In other words, the silicon crystal 12 starts to be grown in the horizontal direction by using the tip end of the nano silicon as a core.

At this time, also from a portion grown in the horizontal direction, the silicon crystal is grown in the thickness direction of the silicon thin film 10. Then, the growth speed of the silicon thin film 10 in the thickness direction and the growth speed thereof in the horizontal direction are almost the same, and, on the inert face 36, as illustrated in FIG. 4, the growth in the horizontal direction and the growth in the thickness direction advance while forming a growth face 46 that is inclined by about 45 degrees with respect to the thickness direction of the silicon thin film 10.

As illustrated in FIG. 5, when the growth further advances, the silicon crystal 12 also covers areas on the inert faces 36 so as to allow the silicon crystal 12 to be connected on the inert faces 36, and accordingly, the entire face of the silicon substrate 32 is covered with the silicon thin film 10. Thereafter, as illustrated in FIG. 6, in order to raise the speed, the mixing of the hydrogen chloride gas into the raw material gas 28 is stopped, and the temperature of the silicon substrate 32 is raised, and the growth process proceeds until the silicon crystal reaches the necessary epitaxial thickness, and then, the growth process ends.

Since the silicon thin film 10 formed as above is a crystal that is grown by using the silicon pillars 12a located on the exposed face 34 as cores, both the silicon crystal 12 located on the exposed face 34 and the silicon crystal 12 located on the inert face 36 are formed as a continuous film-shaped crystal film of a single crystal that succeeds the crystal structure of the silicon substrate 32. Meanwhile, while an atomic covalent bond between the silicon substrate 32 and the silicon crystal 12 is formed on the exposed face 34 (the pitch Wa), it is difficult for a covalent bond between the thermally-oxidized film forming the inert layer 38 and the silicon thin film 10 to be formed on the inert face 36 (the pitch Wb), and accordingly, the mechanical strength of this portion is lower than that of the covalent bond.

In addition, as illustrated in FIGS. 5 to 7, in the above-described process, valley portions 48 formed by the growth faces 46 inclined by about 45 degrees, which appear in the above-described horizontal growth step and of which the cross-sections are isosceles triangles, are formed on the inert layer 38, and portions at which the valley portions 48 appear form positions at which the silicon thin film 10 is formed with the smallest thickness. Here, in a case where the width of the inert layer 38 is 10 µm, the depth of the valley portion 48 is about 5 µm. Accordingly, in a case where the silicon thin film 10 is grown by 30 µm, the thickness of the silicon thin film 10 is 25 µm at the deepest portion of the valley portion 48. Therefore, the variation of the thickness of the silicon thin film 10 is (30 µm - 25 µm)/30 µm = 17%.

As illustrated in FIG. 7, the silicon pillars 12a grown on the exposed faces 34 are grown as the above-described nano silicon. When the silicon thin film 10, which is grown on the silicon substrate 32, is peeled off by applying an external force from the end portion of the silicon thin film 10, the silicon pillar 12a (S1), which is grown on the end-most portion side on the exposed face 34 and has nano properties, starts to be stretched, and, as the external force increases, the silicon pillar 12a (S1) is further stretched, and, simultaneously, the silicon substrate 12a (S2) of the next stage located to the inner side of the end portion starts to be stretched. Finally, the silicon pillar 12a (S1) located at the forefront reaches partial peeling-off. Then, the silicon pillar 12a (S2) of the next stage is changed to be located at the forefront position and then reaches the partial peeling-off. Such a repetition is continued, and the static sequential peeling-off advances for the entire face of the silicon substrate 32. According to this peeling-off method, stress is concentrated only on very limited silicon pillars 12a of the silicon pillar 12a located at the forefront and the silicon pillars 12a located on the next stage and a stage next to the above-described next stage. Accordingly, since the static peeling-off can be performed sequentially from the end, the silicon thin film 10 having a large area can be formed without applying a large external force thereto.

However, in the first embodiment, since the thermally-oxidized film is used in the inert layer 38, in a case where the bonding between the thermally-oxidized film and the silicon thin film 10 is strong, it is difficult to peel off the silicon thin film 10. Accordingly, in the first embodiment, when the peeling-off is performed, an etching solution such as hydrofluoric acid is supplied to the end portion, which is to be peeled off, of the silicon thin film 10 by using a spray or the like (not illustrated in the figure). Then, the silicon thin film 10 can be peeled off from the portion for which the etching has been performed, and the silicon pillar 12a located at the forefront is stretched and partially peeled off owing to dissolution of the thermally-oxidized film, whereby the inert layer 38 located on the next stage can be etched, and the silicon pillar 12a located on the next stage can be stretched and partially peeled off. Accordingly, by continuously supplying the etching solution to portions, which are to be peeled off, of the silicon thin film 10, the peeling-off of such portions is sequentially repeated in a static manner, whereby the entire face of the silicon thin film 10 can be peeled off from the silicon substrate 32.

In this embodiment, the nano properties of the silicon crystal (silicon pillar) grown at the exposed face 34, in other words, a physical property of being stretched in proportion to an external force before the breaking thereof is used. Accordingly, the dissolution using hydrofluoric acid can be performed at the oxide film. In such a case, a strong external force is not necessary for peeling off the inert layer 38, and the external force is concentrated only on the silicon pillars 12a located near the forefront of the peeling-off. Accordingly, this embodiment is different from a peeling-off method in which an external force is simultaneously and instantly applied to both parties including an extremely large number of inert films and silicon pillars formed on a wafer using a reinforcing plate of which bending is suppressed. In addition, although an example has been described in which an oxide film is used as the inert layer 38, in a case where a silicon nitride film is grown as the inert layer 38, any solution that is optimal for dissolving the silicon nitride film may be used. In addition, in order to prevent a scratch being formed on the surface of the silicon thin film 10, a protection sheet (not illustrated in the figure) that can be easily bent (flexible) may be attached to the surface of the silicon thin film 10 before peeling-off, which can be similarly applied to the embodiments described below.

FIG. 8 illustrates a silicon thin film after being peeled off. As illustrated in FIG. 8, the silicon thin film 10 after peeling-off is a silicon thin film 10 which is formed by the silicon crystals 12 in a form in which a plurality of convex portions 12b is arranged on the principal face thereof. The convex portion has a width in the range of 0.001 µm to 1 µm, and at the tip end 12c of the convex portion 12b, a peeling-off mark that is formed in a form of tearing off the silicon crystal 12 is included.

Here, the convex portions 12b can be formed by forming the silicon pillars 12a on the exposed faces 34 formed together with the inert faces 36 on the above-described silicon substrate 32, and the silicon thin film 10 can be formed by growing the silicon crystal 12 in the horizontal direction by using the silicon pillars 12a formed on the exposed faces 34 as cores. Then, the silicon pillars 12a formed on the exposed faces 34 are formed as nano silicon from the exposed faces by configuring the size of the exposed faces 34 as the above-described size. Accordingly, since the silicon pillars 12a are formed as nano silicon, by applying stress to the silicon thin film 10, the silicon film 10 is stretched and is peeled off from the silicon substrate 32, and a peeling-off mark is formed at the tip end 12c of the convex portion 12b. In addition, in a case where the silicon thin film 10 is peeled off from the silicon substrate 32, stress is concentrated only on the limited silicon pillars 12a including the silicon pillar 12a located at the forefront, the silicon pillar of the next stage, and the silicon pillars 12a of the next stage and a stage next to above-described next stage. Accordingly, static peeling-off can be sequentially performed from the end, therefore the silicon thin film 10 can be formed so as to have a large area without applying a strong external force.

A method of manufacturing a silicon thin film according to a second embodiment is basically similar to the method according to the first embodiment but is different from that of the first embodiment in that the inert layer 38 is formed by using a material having breaking strength lower than that of the silicon thin film. In a case where a material having breaking strength lower than that of the silicon thin film 10, for example, a natural oxide film is used for forming the inert layer 38, a bonding force between atoms is weak in the natural oxide film, and accordingly, the inert layer 38 can be easily broken. Accordingly, the inert layer 38 can be broken without damaging the silicon thin film 10, or an interface between the inert layer 38 and the silicon substrate 32 or an interface between the inert layer 38 and the silicon thin film 10 can be broken, whereby the silicon thin film 10 can be easily peeled off from the silicon substrate 32. In this embodiment, other than the natural oxide film, a low-temperature deposited oxide film or a low-temperature nitride film can be used.

The natural oxide film is a film that is uniformly formed on the surface by exposing the surface of the silicon substrate 32 to the air (oxygen) under normal temperature for a predetermined time, is an oxide film that is incomplete oxygen rich in a stoichiometric sense as the oxide film, and has a thickness of about 25 Å. In addition, since the bonding force between atoms and at the interface is weaker than that of the thermally-oxidized film to be described later, the natural oxide film can be easily broken. Accordingly, as will be described later, the silicon thin film 10 that is bonded to the inert face configured by the natural oxide film can be easily peeled off from the silicon substrate 32. The patterning of the natural oxide film is formed by forming a resist film (not illustrated in the figure) corresponding to the patterning on the surface of the silicon substrate 32 on which the natural oxide film is formed, removing an area in which the natural oxide film is exposed by performing etching using hydrofluoric acid or the like, and then removing the resist film (not illustrated in the figure).

In addition, in a case where the low-temperature deposited oxide is formed as the inert face, for example, a method of depositing an oxide film on the surface of the silicon substrate by using a gas acquired by mixing oxygen (O₂) into monosilane (SiH₄) (Reaction Formula: SiH₄ + O₂ => SiO₂ + 2H₂) can be used. For example, in a case where mixed gas of monosilane gas in which the concentration of oxygen is 13% is heated so as to raise the temperature thereof to 350°C is supplied to the silicon substrate 32, the deposited oxide film can be formed at the speed of 0.1 µm/min.

The low-temperature deposited oxide film (or nitride film) is an oxide film (nitride film) that does not directly oxidize (nitride) the silicon substrate 32 but grows a silicon oxide (nitride) on the surface of the substrate or coats the surface of the substrate with a silicon oxide (nitride), using gas or liquid.

For example, when described as a method of coating the low-temperature deposited oxide film with a liquid, by putting silicon powders into an ammonia liquid, silicon is dissolved so as to form Si(OH)₄, and then, by falling Si(OH)4 into drops onto the surface of a substrate, the entire surface is uniformly coated therewith by using a spinner utilizing the property of silicon of being wet well in alkaline fluid. Thereafter, the ammonia liquid is dried (Si(OH)₄ → SiO₂ + H₂O). The low-temperature deposited oxide film formed after being dried is an oxide film that is, compared to the thermally-oxidized film, extremely frail and is incomplete in a stoichiometric sense. Accordingly, in this embodiment, the oxide film is favorable.

As described above, when silicon is exposed to the air under normal temperature for a predetermined time, a natural oxide film is formed on the surface thereof, and accordingly, there is a case where, when a silicon crystal 12 (silicon thin film 10) is epitaxially grown on a silicon substrate 32 that is patterned by forming a natural oxide film as an inert face 36, the oxide film of the exposed face 34 is removed using hydrogen gas in the initial phase of epitaxial growth, and thereafter, the silicon crystal 12 (silicon pillar 12a) is grown. At that time, the natural oxide film as the inert layer 38 is simultaneously reduced, and the film thickness becomes slightly thinner. In such a case, in order to use the natural oxide film industrially-stably as the inert film, the epitaxial growth may be performed by building up the above-described low-temperature deposited oxide film on the natural oxide film as the inert layer 38 and supplementing a decrease at the time of reduction of hydrogen in advance (in some cases, the film is increased). In order to increase the growth of the silicon pillars 12a at the time of peeling-off (the coefficient of extension is the same), it is effective to increase the thickness of the low-temperature deposited oxide film.

Although the manufacturing process of the silicon thin film according to the second embodiment is different from that according to the first embodiment in the manufacturing process of the inert layer 38 as described above, the process until the silicon thin film 10 is grown is the same as that according to the first embodiment (see FIGS. 2 to 5). In addition, the process of peeling off the silicon thin film 10 from the silicon substrate 32 as illustrated in FIG. 6 is similar to that according to the first embodiment. However, as in this embodiment, in a case where a material having breaking strength lower than that of the silicon thin film 10, for example, a natural oxide film is used in the inert layer 38, the bonding force between atoms is low, so that the natural oxide film may be easily broken. Accordingly, without damaging the silicon thin film 10, the inert layer 38 can be broken, or the interface between the inert layer 38 and the silicon substrate 32 or the interface between the inert layer 38 and the silicon thin film 10 can be broken, whereby the silicon thin film 10 can be easily peeled off from the silicon substrate 32.

Thus, according to the second embodiment, unlike the first embodiment, dry peeling-off can be performed in which peeling-off can be performed without etching the inert layer 38 using an etching solution such as hydrofluoric acid. Also in this embodiment, although the nano properties of nano silicon are utilized, and accordingly, the static sequential partial peeling-off starting from the end portion of the silicon thin film 10 is applied, there is resistance of the inert layer 38 that is higher than that of the first embodiment, and accordingly, the force necessary for the peeling-off increases as that much. However, since dry peeling-off is used, the peeling-off process can be performed in an easy manner. It is apparent that, also in this embodiment, it is preferable to use an etching solution, and promotion of peeling off between the inert face 36 and the silicon thin film 10 and the removal of the inert layer 38 attached to the silicon thin film 10 can be simultaneously performed.

In addition, as in Japanese Patent Application Laid-Open No. 6-20945 and Japanese Patent Application Laid-Open No. 4-199749, in a case where peeling-off is instantly performed in a state that a reinforcing plate that suppresses bending is bonded when a thin film after growth is peeled off, an external force is not directly applied to the thin film, and accordingly, the thin film is not damaged. However, in the second embodiment, since the reinforcing plate is not used, an external force is applied to the thin film in a case where the silicon thin film 10 after growth is peeled off. Accordingly, in order to avoid damaging of the silicon thin film 10 at the time of peeling-off, there is a prerequisite that the breaking strength of the inert layer 38 is less than that of the silicon thin film 10.

In addition, in the first embodiment and the second embodiment, although drag from the silicon pillars 12a needs to be considered for the silicon thin film 10 when the peeling-off is performed, the width (the length of one side) of the proposed silicon pillar 12a is 1 µm or less, and the thickness of a portion of the silicon thin film 10 that is formed right above the silicon pillar 12a at a time when one side of the thin film is grown in the horizontal direction through selective growth and is grown until the entire face of the silicon substrate 32 is covered is 10 µm or more. Accordingly, the silicon thin film 10 has sufficient strength for the drag from the silicon pillars 12a at the time of peeling-off, and therefore, the silicon thin film 10 is not damaged at the time of peeling-off.

Although a method of manufacturing a silicon thin film according to a third embodiment is basically similar to that according to the second embodiment, there is a difference that the chemical composition of the oxide film configuring the inert layer 38 is configured to be stoichiometrically oxygen-rich. The object of the third embodiment is to peel off the silicon thin film 10 from the silicon substrate 32 in an easy manner by supplying oxygen to the silicon pillars 12a that are in the middle of the growing process from the oxide film that is in the oxygen-rich state and oxidizing the periphery of each silicon pillar 12a so as to make the silicon pillar 12a thinner or blocking a connection of covalent bonding between the silicon thin film 10 and the silicon substrate 32 through the silicon pillar 12a by oxidizing up to the inside of the silicon pillar 12a.

As the oxide film used in the third embodiment, for example, the natural oxide film or the low-temperature deposited oxide film described in the second embodiment can be used, and the oxide film that is stoichiometrically oxygen-rich can be formed by raising the partial pressure of oxygen through the above-described reaction or the like.

FIG. 9 illustrates an initial process according to a method of manufacturing a silicon thin film of the third embodiment, FIG. 10 illustrates a selective growth process according to the method of manufacturing a silicon thin film of the third embodiment, and FIG. 11 illustrates a thin-film forming process according to the method of manufacturing a silicon thin film of the third embodiment.

As illustrated in FIG. 9, the inert layer 38 is configured by a natural oxide film or a low-temperature deposited oxide film, and the inert face 36 is formed by the exposed face 34 of the silicon substrate 32 and the inert layer 38 by forming the inert layer 38 by an oxide film of which the chemical composition is stoichiometrically oxygen-rich. Then, by supplying the raw material gas 28, the silicon pillars 12a are grown at the exposed surfaces 34, and oxygen contained in the inert layer 38 is supplied from the outer circumference of the silicon pillar 12a due to the state of the silicon pillar 12a of being brought into contact with the inert layer 38, whereby oxidation from the outer circumference of the silicon pillar 12a progresses.

Accordingly, as illustrated in FIG. 10, as the growth stretches in the horizontal direction, the side face of the silicon pillar 12a grown at the exposed face 34 is started to be oxidized by the inert layer 38 that is in the oxygen-rich state, and the outer circumference of the silicon pillar 12a is altered to the oxide film 12d so as to make the silicon pillar 12a thinner. At this time, oxygen supplied from the inert layer 38 is diffused into the silicon pillar 12a, and a boundary between a diffusion front, that is, an area into which oxygen has already been diffused and which is changed to an oxide and an area into which oxygen has not been diffused forms a parabola (paraboloid).

Finally, during the selective growth process and during subsequent performance of a heat treatment, the silicon pillar 12a surrounded by the inert layer 38 that is in the oxygen rich state is further oxidized from the side, the oxide film 12d that is formed by oxidizing the silicon pillar 12a is grown so as to cover the exposed face 34 (FIG. 10), the diameter of the silicon pillar 12a is made further thinner due to oxidation, and finally, the entirety of the silicon pillar 12a is oxidized, whereby the oxide film 12d is formed on the exposed face 34 (FIG. 11). In addition, as illustrated in FIGS. 10 and 11, also in the third embodiment, a valley portion 48 is formed on the inert layer 38 which is formed by growth faces 46, which appear in the above-described horizontal growth step, inclined by about 45 degrees and of which the cross-section forms an isosceles triangle.

In this state, on the entire face of a portion interposed between the silicon substrate 32 and the silicon thin film 10, the oxide film 12d is formed (extends). At this time, the inert layer 38 and the oxide film 12d that is formed by oxidizing the silicon pillar 12a extend to the entire face of the silicon substrate 32. In such a case, since the entirety of the silicon pillar 12a is oxidized, the natural oxide film and/or the low-temperature deposited oxide film do not need to be mechanically peeled off, and as illustrated in FIG. 6, in a case where a hydrofluoric acid spray is used, an external force is not necessary for the peeling-off, and the silicon thin film 10 is peeled off from the silicon substrate 32.

The above-described process can be performed when the insulating oxide film that is stoichiometrically oxygen-rich supplies oxygen that is sufficient for oxidizing the silicon pillars 12a. As one method, as described above, in a method in which oxygen gas is mixed into monosilane gas, and the low-temperature deposited oxide film is deposited to the surface of the silicon substrate 32, extra oxygen gas is added to the mixed gas. In addition, an oxide film can be also used in which Si (OH)₄ acquired by dissolving silicon into an ammonia liquid is dried in a spinning manner on the surface of the substrate.

Generally, a wet oxidation method and a dry oxidation method are used for oxidizing the silicon surface. Although the growth speed of the oxide film according to the dry oxidation method is lower than that according to the wet oxidation method, a complete oxide film can be acquired in the dry oxidation method, and accordingly, the dry oxidation method is frequently used in the IC industry. The oxidation of the silicon pillar 12a according to this embodiment is dry oxidation and contact oxidation between solids. Therefore, it is necessary to expect the oxidation speed to be slower than that of the wet method.

In B.E. Deal and A.S. Grove. J. Appl. Phys. 36 (1965) 3770-3776, the thickness of the oxide film formed in the silicon pillar 12a is calculated for each case in a case where the dry oxidation method is used for silicon, and thick growing of the oxide film is performed.

In FIG. 14, the thickness of the oxide film formed in the silicon pillar is illustrated in a case where a plurality of widths of the inert layer is set, and the silicon pillars are grown until the growth in the horizontal direction is completed (see FIG. 5). In FIG. 14, a time until the silicon pillars 12a are epitaxially grown on the exposed faces 34 of the silicon substrate 32, the silicon crystal 12 is grown in the horizontal direction on the inert layer 38 (an oxide film that is oxygen-rich), and the inert layer 38 is covered with the silicon crystal 12 and the thickness of the oxide film formed on the side face of the silicon pillar at that time are calculated for each case.

As illustrated in FIG. 14, in Case 1, the width (the length of one side) of the inert layer 38 is configured as 10 µm, and in Case 2, the width (the length of one side) of the inert layer 38 is configured as 1 µm. When the epitaxial growth temperature and the growth speed are 1000°C and 0.3 µm/min in Cases 1 and 2, the growth speed of the oxide film formed on the side face of the silicon pillar 12a is 2.5 µm/min.

As illustrated in FIG. 14, in Case 1, since the width (the length of one side) of the inert layer 38 is 10 µm, the diagonal length is 14.14 µm, and accordingly, the shortest distance required for growth in the horizontal direction is 7.2 µm. Accordingly, a time required for the silicon crystal 12 to cover the inert layer 38 through the growth in the horizontal direction is 24 minutes (7.2 µm/(0.3 µm/min)). On the other hand, during 24 minutes described above, the thickness of the oxide film formed by the silicon crystal 12 is 60 nm (24 min × 2.5 µm/min).

Next, in Case 2, since the width (the length of one side) of the inert layer 38 is configured as 1 µm, the diagonal length is 1.4 µm, and accordingly, the shortest distance required for growth in the horizontal direction is 0.7 µm. Accordingly, a time required for the silicon crystal 12 to cover the inert layer 38 through the growth in the horizontal direction is 2. 4 minutes (0.7 µm/(0.3 µm/min)). On the other hand, during 2.4 minutes described above, the thickness of the oxide film formed by the silicon crystal 12 is 6 nm (2.4 min × 2.5 µm/min).

FIG. 15 illustrates the thickness of the oxide film formed in the silicon pillar in a case where a plurality of growth speeds and a plurality of thicknesses of the silicon thin film to be formed are set, and the silicon thin film is grown up to a predetermined thickness after horizontal growth (see FIGS. 6 and 11). In Case 3, the growth temperature is 1200°C, the growth speed is 1.5 µm/min, and the silicon thin film is grown until the thickness thereof becomes 30 µm. Accordingly, the growth time is 20 minutes (30 µm / (1.5 µm/min)). In Case 4, the growth temperature is 1200°C, the growth speed is 3 µm/min, and the silicon thin film 10 is grown until the thickness thereof becomes 30 µm. Accordingly, the growth time is 10 minutes (30 µm / (3 µm/min)). In Case 5, the growth temperature is 1200°C, the growth speed is 1.5 µm/min, and the silicon thin film 10 is grown until the thickness thereof becomes 20 µm. Accordingly, the growth time is 13.3 minutes (20 µm / (1.5 µm/min)). In Case 6, the growth temperature is 1200°C, the growth speed is 1.5 µm/min, and the silicon thin film 10 is grown until the thickness thereof becomes 40 µm. Accordingly, the growth time is 26.7 minutes (30 µm / (3 µm/min)).

Next, the thickness of the oxide film that is formed on the side face of the silicon pillar 12a is calculated in correspondence with the growth time of each one of Cases 3 to 6. In each case, the temperature (1200°C) is the same, and the parabola rate constant is 0.062 µm²/h (O₂, 760 Torr). Thus, in Case 3, the thickness of the oxide film is acquired by calculating (0.062 × 20 / 60)^{1/2} to be 0.1437 µm ≈ 144 nm (see a numeric equation illustrated in FIG. 15). Similarly, in Case 4, the thickness of the oxide film is acquired by calculating (0.062 × 10 / 60)^{1/2} to be 0.1017 µm ≈ 102 nm, and in Case 5, the thickness of the oxide film is acquired by calculating (0.062 × 13.3 / 60)^{1/2} to be 0.117 µm = 117 nm. Furthermore, in Case 6, the thickness of the oxide film is acquired by calculating (0.062 × 26.7 / 60)^{1/2} to be 0.166 µm = 166 nm.

Accordingly, for example, in a combination of Case 1 and Case 3, in other words, in a case where, in a state that the width of the inert layer 38 is 10 µm, and the growth temperature is 1000°C, the silicon pillar 12a and the silicon crystal 12 are grown on the exposed face 34 located on the silicon substrate 32, the silicon crystal 12 is grown in the horizontal direction until it covers the inert layer 38 (selective growth process), and thereafter, the silicon thin film 10 is grown up to a thickness of 30 µm (thin-film growing process), the thickness of the oxide film formed in the silicon pillar 12a is (60 nm + 144 nm) to be 204 nm. Accordingly, in this case, in order to completely oxidize the silicon pillars 12a during the epitaxial growth and acquire the silicon thin film 10 through dissolution of the oxide film using hydrofluoric acid without using an external force for peeling off the silicon thin film 10, it is understood that the width (the length of one side) of the silicon pillar 12a, that is, the width (the length of one side) of the exposed face 34 may be set to 400 nm (the calculation result is 408 nm = 204 nm × 2) or less.

In addition, for example, in a combination of Case 2 and Case 4, in other words, in a case where the width (the length of one side) of the inert layer 38 is 1 µm, and the growth speed at the thin-film growing process is 3 µm/min, the thickness of the oxide film formed in the silicon pillar 12a is (6 nm + 102 nm) to be 108 nm. Accordingly, in this case, in order to completely oxidize the silicon pillars 12a during the epitaxial growth and acquire the silicon thin film 10 through dissolution of the oxide film using hydrofluoric acid without using an external force for peeling off the silicon thin film 10, it is understood that the width (the length of one side) of the silicon pillar 12a, that is, the width (the length of one side) of the exposed face 34 may be set to 216 nm (= 108 nm × 2) or less. Similarly, in a combination of Case 2 and Case 3, it is understood that the width (the length of one side) of the silicon pillar 12a, that is, the width of the exposed face 34 may be set to 300 nm (= (6 nm + 144 nm) × 2) or less.

Here, in a case where the silicon thin film is used as a photovoltaic cell, although a thickness of about 30 µm is necessary as in Case 4 or Case 5, this embodiment is not limited thereto, and, in consideration of a broader application, as in Case 5, there is a case where a thin film having a thickness of 30 µm or less is necessary. Thus, as described above, in a case where Case 1 and Case 5 are combined, it is understood that the width (the length of one side) of the silicon pillar 12a, that is, the width of the exposed face 34 is set to 354 nm (= (6 nm + 144 nm) × 2) or less. In addition, in a case where the film thickness of the silicon thin film 10 is set to be thin as in Case 5, the oxidation time of the silicon pillar 12a decreases in proportion thereto, and thus it is necessary to set the width (the length of one side) of the silicon pillar 12a, that is, the width (the length of one side) of the exposed face 34 to a smaller value to that extent.

Furthermore, it is necessary to consider the thickness of the oxide film (the width of the exposed face 34) of a case where the thickness of the silicon thin film 10 exceeds 30 µm described above and is grown so as to have a thickness of 40 µm as in Case 6. For example, in a case where a combination of Case 1 and Case 6 is considered, it is understood that the width (the length of one side) of the silicon pillar 12a, that is, the width of the exposed face 34 may be set to 450 (the calculation result is 452 nm = (60 nm + 166 nm) × 2) or less.

In addition, the oxidation phenomenon of the silicon pillar 12a is calculated by using so-called a "Deal-Grove model" disclosed in B.E. Deal and A.S. Grove. J. Appl. Phys. 36 (1965) 3770 - 3776. In addition, in calculating the growth speed, a linear rate constant is used at the time of selective growth, and a parabola rate constant is used at the time of thin-film growth, and the growth of the oxide film on the side face of the silicon pillar 12a during the growth of the silicon pillar 12a until the growth in the horizontal direction is started is excluded in the calculation.

This model represents a calculation method in a case where oxygen atoms (dry oxygen) are sufficiently supplied to the silicon surface. This embodiment is achieved in a case where oxygen atoms are sufficiently supplied from the inert layer 38 that is in a oxygen-rich state due to contact between solids on the side face of the silicon pillar 12a, and accordingly, the calculated oxidation speed of the silicon pillar 12a is determined as a maximum value. Accordingly, in a case where the oxidation of the silicon pillar 12a is insufficient, the oxidation of the silicon pillar 12a may be achieved by appropriately extending an additional heat process time after the epitaxial growth or setting the width of the silicon pillar 12a to be thin in advance.

Although the silicon crystal 12 that is grown in the horizontal direction as in this embodiment is in contact with the inert layer 38, and thus the inert layer 38 oxidizes not only the silicon pillars 12a but also the surface that is in contact with the inert layer 38 of the silicon thin film 10, the inert layer 38 can be removed by etching using hydrofluoric acid at the time of peeling-off.

When the width of the silicon pillar 12a, that is, the pitch Wa is set to 0.01 µm, the inert layer 38 (oxidation film) that is stoichiometrically oxygen-rich oxidizes the silicon pillar 12a only during the epitaxial growth process even in a case where an additional heat treatment is not performed for the silicon pillar 12a. Accordingly, through employing immersion into hydrofluoric acid, spraying of hydrofluoric acid, or the like, the silicon thin film can be acquired by peeling off the silicon thin film from the silicon substrate without applying a strong external force for the peeling-off, and accordingly, manufacturing of a high-quality silicon thin film (through multi-seed epitaxial growth), of which the variation of the thickness is small (1.7%) as described above, that does not depend on an external force can be performed. In addition, according to Japanese Patent Application Laid-Open No. 6-20945 and Japanese Patent Application Laid-Open No. 4-199749 that propose silicon pillars having a larger width, the above-described nano silicon is not formed, and accordingly, it is difficult to peel off the silicon thin film after growth from the substrate, and, in order to oxidize the silicon pillar, an additional heat treatment is needed much, therefore, which makes it difficult to be practically used.

In addition, it is understood that the rate of progression of oxidation of the silicon pillar 12a (about 0.1 µm per hour) is sufficiently slower than the growth speed of the silicon pillar 12a (about 30 µm per hour). Accordingly, the entirety of the silicon pillar 12a is not oxidized up to the inside thereof before the silicon pillar 12a is grown up to the height of the inert face 36, and the tip end portion of the silicon pillar 12a used for the growth in the horizontal direction is oxidized a little on the side face thereof, whereby it is understood that there is no situation in which the growth of the silicon crystal 12 in the horizontal direction is blocked.

In the third embodiment, after the formation of the silicon thin film 10, the silicon pillars 12a may not be completely eliminated. In this embodiment, by forming the silicon pillars 12a by sufficiently drawing out the crystal structure of the silicon substrate 32 from the entirety of the exposed face 34 at the time of growth, a high-quality silicon thin film 10 can be formed by using the silicon pillars 12a as cores, and, even in a case where the silicon pillars 12a are oxidized so as to be thinner at the time of forming the silicon thin film 10, there is no difference in that the properties of the nano silicon are included. Accordingly, by lowering the breaking strength of the silicon pillars 12a without preventing the extensibility of the silicon pillars 12a, the silicon thin film 10 can be easily peeled off by a small external force.

FIG. 12 illustrates the silicon thin film after peeling-off according to the third embodiment. The silicon thin film 10 formed in the third embodiment is formed by the silicon crystal 12 and has a plurality of convex portions 12b arranged on the principal face thereof. The convex portion 12b has a width in the range of 0.001 µm to 1 µm, and, at the tip end 12c of the convex portion 12b, a peeling-off mark formed in a form of tearing off the silicon crystal 12 and an etching mark acquired by removing the silicon oxide film formed at the tip end 12c of the convex portion 12b through etching are included. In addition, in a case where the thickness of the silicon thin film is 30 µm, and the width of the convex portion is 0.4 µm or less (0.408 µm or less according to the above-described calculation result), the tip end 12c of the convex portion 12b has the above-described etching mark.

In a case where the silicon pillar 12a is oxidized in accordance with the growth of the silicon thin film 10, the silicon pillar 12a that has been oxidized is etched by hydrofluoric acid or the like, and accordingly, at the tip end 12c of the convex portion 12b, an etching mark (a concavo-convex shape of the interface between the silicon thin film 10 and the oxidized silicon pillar 12a) is formed. In addition, in a case where the silicon pillar 12a is not completely oxidized, since oxidation progresses from the outer side of the silicon pillar, an etching mark is formed on the peripheral edge of the tip end 12c, and a peeling-off mark is formed to the inner side thereof.

As a fourth embodiment, in a manufacturing process of a silicon thin film in which a silicon thin film is formed, a thin film may be grown on the silicon substrate (not shown) having a curve-shaped surface. In order to install a photovoltaic cell by utilizing a functional surface such as a roof of a vehicle, a photovoltaic cell following the surface shape is necessary. Although an amorphous Si formed in a sheet shape or a microcrystal Si photovoltaic cell can be formed in a curved shape, generally, a silicon substrate has a sheet shape of a quadric surface. The photovoltaic cell is amorphous or multi-crystalline, and a single crystal does not grow. In this embodiment, by growing a thin film by forming a cubic surface on the substrate surface in advance, a three-dimensional single crystal thin film can be manufactured. While elaboration and costs are necessary for substrate design, a substrate can be repeatedly used and can be industrially produced on a large scale.

As a fifth embodiment, the material that forms the inert layer 38 may be doped with a P-type or N-type dopant. In a manufacturing process of a silicon thin film 10 in which the silicon thin film 10 is formed, a silicon thin film is formed after an inert layer 38, which is formed on the silicon substrate 32, mixed with a P-type or N-type dopant in advance is formed such that a face brought into contact with the inert face of the silicon thin film 10 is grown as a P-type or N-type. In a case where the inert layer 38 is formed by a low-temperature deposited oxide film, in order to mix a P-type or N-type impurity into the inert layer 38, the inert layer 38 may be formed by mixing an appropriate amount of phosphine or boran gas into monosilane gas.

According to this method, a face of the silicon thin film 10 that is brought into contact with the inert face 36 is formed as a P-type or N-type surface through solid diffusion in simultaneously with the growth of the silicon thin film 10, and it can be used as a PN junction or an electrode layer of which the surface resistance is low. Accordingly, a separate process of forming an electrode layer is not necessary, whereby an increase in cost can be suppressed.

As a sixth embodiment, in a manufacturing process of a silicon thin film, by doping raw material gas 28 with a P-type or N-type dopant and by alternately doping with the P-type dopant and the N-type dopant in the middle of the manufacturing process of the silicon thin film 10, PN junctions can be formed in the thickness direction of the silicon thin film 10. As an example of the P-type dopant, there is boron (B), and as an example of the N-type dopant, there is phosphorus (P). As the manufacturing process, it may be configured such that, first, the raw material gas 28 containing several dopants of the P-type and the N-type is supplied to the silicon substrate 32 for which the exposed face 34 and the inert face 36 are patterned, and, at time when the growth of the silicon crystal 12 on the inert face 36 is completed and reaches a predetermined thickness on the inert face 36, the dopant is changed, and the raw material gas 28 may be supplied until a predetermined thickness is formed.

As a seventh embodiment, on at least one side (or the entire periphery) of the peripheral edge area of the silicon substrate 32, an area ratio of the inert face 36 to the exposed face 34 may be preferably higher than that in the central area of the silicon substrate 32. In other words, in the above-described one side, a ratio Wb/Wa of the area (in proportion to the pitch Wb) of the inert face 36 to the area (in proportion to the pitch Wa) of the exposed face 34 may be preferably set to be larger. In such a case, at a position of the silicon thin film 10 that faces the above-described one side, the ratio of the area combined with the silicon substrate 32 decreases. Accordingly, one side of the silicon substrate 32 located at the above-described position can be easily peeled off, the one side can be used as a peeling tab, and the entire silicon film 10 can be easily peeled off from the silicon substrate 32 by using the peeling tab as a starting point, whereby a yield ratio of the silicon thin film 10 can be raised.

FIG. 13 represents a schematic diagram illustrating a method of manufacturing a silicon thin film according to an eighth embodiment. As the eighth embodiment, an exposed face 40 in which an inert face 42 as described above and the above-described silicon thin film 10 are exposed is newly formed on the silicon thin film 10 after growth, and a new silicon thin film 44 can be formed on the silicon thin film 10. At this time, the exposed face 40 formed on the silicon thin film 10 is preferably located at a position overlapping the exposed face 34 formed on the silicon substrate 32 in the plan view. In the silicon thin film 10, an area formed on the exposed face 34 is considered to be formed thickest and to have the least variation in the thickness direction, and accordingly, it is understood that the variation of the new silicon thin film 44, which is formed on the silicon thin film 10, in the thickness direction can be small. In addition, by forming a new inert face and a new exposed face also on the new silicon thin film 44, the silicon thin films can be formed on multiple stages. When the peeling-off is performed, the sheets may be sequentially peeled off one by one starting from the uppermost silicon thin film. By using such a method, silicon thin films having a multi-layer structure can be formed by using one silicon substrate 32, and accordingly, the silicon thin films can be produced in a large scale. In addition, in order to easily form the inert face of the second stage and after that, it is preferable that the width of the inert face is small, and the depth of the valley portion 48 (see FIG. 8) formed by the growth in the horizontal direction is small.

In addition, the fourth to eighth embodiments can be applied to the first to third embodiments in an overlapping manner. Furthermore, as in the second embodiment, in a case where etching using a hydrofluoric acid spray is not essential, various oxide films provided so as to be used are in a state of being attached to the silicon thin film 10 and the silicon substrate 32. However, the oxide films attached to the silicon thin film 10 can be easily removed through etching. On the other hand, the oxide film (the inert layer 38) that is attached to the silicon substrate 32 is completely removed in a case where a concavo-convex (a portion that is bonded to the tip end 12c of the convex portion 12b before peeling-off) formed in a portion of the surface of the silicon substrate 32 from which the silicon thin film 10 is peeled off is mirror polished. Thus, according to any one of the embodiments, the silicon substrate 32 can be reused. This similarly applies to a case where a silicon nitride film is formed as the inert layer 38. In addition, it is apparent that, by forming electrodes on both faces of the silicon thin film 10 formed according to the first to eighth embodiments, a silicon thin-film photovoltaic cell can be formed.

### Example

Next, an example that is more specific than the invention will be described.

### Results

A silicon thin film was epitaxially grown on a five-inch silicon substrate by using trichlorosilane gas (0.3mol%). The silicon substrate was a mirror polished wafer used as a semiconductor IC. In this case, the silicon wafer was used that had been well packed during three months after the cleaning date thereof.

In order to reduce and remove a natural oxide film placed on the silicon substrate, after being processed at 1200°C for one minute in a hydrogen atmosphere, the silicon substrate was epitaxially grown at 1150°C for 20 minutes. The finished silicon epitaxial wafer was cleaned using a cleaning solution, and 2/3 area was a normal epitaxial wafer, but a 1/3 area was peeled off from the mirrored wafer so as to be in a curl shape. In an inert layer area, although it was formed by accident, a silicon single crystal film of 20 micrometer that represents a silicon surface appropriate for the occurrence of a nonuniform decomposition reaction of trichlorosilane gas was formed. In the 2/3 area, the formation of the inert layer was insufficient, and the area was grown as a normal epitaxial wafer (film-shaped peeling-off did not occur). The formed thin film-state silicon was in a curl shape and was simply peeled off without applying any specific force thereto.

### Evaluation of Result

The entire silicon surface is covered with a thin natural oxide film in a short time after cleaning. As preprocessing of the epitaxial growth, generally, a thin natural oxide film or an organic material formed on the surface is decomposed by hydrogen, and then silicon growing using trichlorosilane gas is performed. Regarding this peeling-off phenomenon, the process of the previous step was incomplete, and thus, the natural oxide film partially and finely remained in an alternating manner, and accordingly, the oxide film oxidized the side face of the fine silicon pillar at the time of growth in the horizontal direction, so that the peeling-off phenomenon occurred. The oxide film oxidizes silicon pillars owing to a contact between solids from the natural oxide film, and consequently, it is estimated that a silicon oxide film is formed for the entire face below the silicon thin film. In order to industrially and effectively perform such a process, as described above, the formation of an exposed face that becomes an active face for the epitaxial growth of silicon and an inert face needs to be contrived, and thus the invention is proposed.

The method of forming the active layer (exposed face) and the inactive layer (non-exposed face) needs to be researched further from now, and, by researching a method of alternately forming both layers, implementing the method in an epitaxial device, and using gas such as trichlorosilane or silicon tetrachloride that has a strong surface chemical reaction, silicon films can be reliably prepared industrially. In the initial period of growth, that is, a stage at relatively low growth temperature, in which growth is started in the active layer of the silicon surface and growth is suppressed in the inactive layer area, the growth speed is low. However, in order to industrially overcome the low growth speed, the development of a formation method in which the formation of the active layer and the inactive layer on silicon is fine in an atomic sense as described above is demanded, and when such a method is developed, peeling-off area can be performed over a large area.

Regarding the growth gas, from the viewpoint of aggressively utilizing the surface chemical reaction, generally, as described above, hydrogen chloride (HCl) gas is mixed into silane gas (for example, trichlorosilane gas) at a constant ratio, and the surface chemical reaction is promoted. However, at this time, the hydrogen chloride gas was not added. In the future, in order to acquire the conditions for selective epitaxial growth that is optimal for peeling-off of the silicon thin film, a further research is necessary.

At any rate, the main point of the invention is to suppress a vapor decomposition reaction of the growth gas and aggressively utilize a surface chemical reaction. Although the selective growing phenomenon is known, thermochemical reaction technology of the gas in the current mechanism has not been developed yet (for example, PCT Publication No. WO2005/069356). In order to effectively produce high-quality thin film crystal silicon according to the invention, basic researches on this reaction are also expected to be promoted.

The silicon substrate provided for thin film growth can be repeatedly used any number of times in principle. In addition, the silicon substrate is greatly advantageous in suppressing the generation of cutting powders when silicon is cut by using a wire saw, which is currently performed, and in reduction of industrial wastes.

In addition, although a thermally-oxidized film, a natural oxide film, or a deposited oxide film is used as the inactive face 36 (the inert layer 38) in this embodiment, any material that is inactive for the crystal growth using the raw material gas 28 may be used, and, for example, a nitride film or the like may be used.

The invention can be used as a manufacturing method that is preferable for effectively preparing a semiconductor having a large area such as a silicon in a thin film state that is used for a silicon photovoltaic cell or the like. In addition, the invention can be used as a method of manufacturing a thin-film state compound photovoltaic cell using a compound other than silicon. Furthermore, by devising the sizes of the pitches Wa and Wb through finely opening the opening portions in the inert layer (inert face) and by devising an application of an oxide film that is stoichiometrically oxygen-rich as a natural oxide film or a deposited oxide film or the like, a thin film, of which the variation is small, not requiring a peeling-off force can be manufactured. Accordingly, the invention is not limited to a photovoltaic cell and can be used as a method of manufacturing a semiconductor thin film material or a semiconductor material that has a high degree of flatness.

### Description of Reference Numerals

- 10: silicon thin film
- 12: silicon crystal
- 12a: silicon pillar
- 12b: convex portion
- 12c: tip end
- 12d: oxide film
- 18: epitaxial growth reactor
- 20: raw gas inlet
- 22: raw gas outlet
- 24: installation base
- 26: heater
- 28: raw material gas
- 32: silicon substrate
- 34: exposed face
- 36: inert face
- 38: inert layer
- 40: exposed face
- 42: inert face
- 44: silicon thin film
- 46: growth face
- 48: valley portion

## Claims

1. A method of manufacturing a silicon thin film in a form in which an inert face formed by an exposed face of a silicon substrate and an inert layer is formed by selectively forming the inert layer on the silicon substrate in which growth of a silicon crystal is inactive for a raw material gas of the silicon crystal, and the silicon crystal is grown from the exposed face such that the silicon crystal covers the silicon substrate by supplying a raw material gas, of which a surface decomposition reaction on the silicon substrate is dominant, out of the raw material gas to the silicon substrate,
wherein, by forming a width of the exposed face in a range of 0.001 µm to 1 µm, the silicon thin film is formed in a state that the silicon thin film can be peeled off from the silicon substrate.

2. The method according to claim 1, wherein an etching agent that etches the inert layer is supplied to an end portion, which is to be peeled off, of the silicon thin film.

3. The method according to claim 1 or 2, wherein the inert layer is formed of a material having breaking strength lower than that of the silicon thin film.

4. The method according to any one of claims 1 to 3, wherein the inert layer is formed by an oxide film, and the oxide film is formed in an oxygen-rich state.

5. The method according to claim 4, wherein, after the silicon thin film is grown, a heat treatment is performed for the oxide film and the silicon thin film.

6. The method according to claim 4, wherein the width of the exposed face is formed so as to be 0.45 µm or less, and a thickness of the silicon thin film is grown until the thickness becomes any specific thickness up to 40 µm.

7. The method according to any one of claims 1 to 6, wherein the material that forms the inert layer is doped with a P-type or N-type dopant.

8. The method according to any one of claims 1 to 7, wherein the silicon substrate is formed in a curved shape, and the inert layer and the silicon crystal are formed on a surface of the curved shape of the silicon substrate.

9. The method according to any one of claims 1 to 8, wherein the raw material gas is doped with a P-type or N-type dopant, and the dopant is switched between the P-type and the N-type during formation of the silicon thin film.

10. The method according to any one of claims 1 to 9, wherein the exposed face on which the inert face and the silicon thin film are exposed is formed on the silicon thin film, and a new silicon thin film is formed on the silicon thin film.

11. The method according to any one of claims 1 to 10, wherein, on at least one side of a peripheral edge area of the silicon substrate, an area ratio of the inert face to the exposed face is higher than that in a center area of the silicon substrate.

12. A method of manufacturing a silicon thin-film photovoltaic cell, wherein electrodes are formed on both faces of the silicon thin film that is formed according to any one of claims 1 to 11.

13. A silicon thin film that is formed by a silicon crystal and has a plurality of convex portions arranged on a principal face thereof,
wherein the convex portions have a width in the range of 0.001 µm to 1 µm and have peeling-off marks that are formed in a form of tearing off the silicon crystal and/or etching marks that are formed in a form acquired by removing a silicon oxide film formed on tip ends of the convex portions through etching at the tip ends of the convex portions.

14. The silicon thin film according to claim 13,
wherein a thickness of the silicon thin film is 40 µm or less,
wherein the width of the convex portion is 0. 45 µm or less, and wherein the etching mark is included at the tip end of the convex portion.

15. A thin-film photovoltaic cell that is formed by forming electrodes on both faces of the silicon thin film according to claim 13 or 14.

## Amended claims

### Amended claims under Art. 19.1 PCT

**1.** A method of manufacturing a silicon thin film in a form in which an inert face formed by an exposed face of a silicon substrate and an inert layer is formed by selectively forming the inert layer on the silicon substrate in which growth of a silicon crystal is inactive for a raw material gas of the silicon crystal, and the silicon crystal is grown from the exposed face such that the silicon crystal covers the silicon substrate by supplying a raw material gas, of which a surface decomposition reaction on the silicon substrate is dominant, out of the raw material gas to the silicon substrate,
wherein, by forming a width of the exposed face in a range of 0.001 µm to 1 µm, while the silicon crystal formed on the exposed face is extended and peeled off, the silicon thin film is formed in a state that the silicon thin film can be peeled off from the silicon substrate.

**2.** The method according to claim 1, wherein an etching agent that etches the inert layer is supplied to an end portion, which is to be peeled off, of the silicon thin film.

**3.** The method according to claim 1 or 2, wherein the inert layer is formed of a material having breaking strength lower than that of the silicon thin film.

**4.** The method according to any one of claims 1 to 3, wherein the inert layer is formed by an oxide film, and the oxide film is formed in an oxygen-rich state.

**5.** The method according to claim 4, wherein, after the silicon thin film is grown, a heat treatment is performed for the oxide film and the silicon thin film.

**6.** The method according to claim 4, wherein the width of the exposed face is formed so as to be 0.45 µm or less, and a thickness of the silicon thin film is grown until the thickness becomes any specific thickness up to 40 µm.

**7.** The method according to any one of claims 1 to 6, wherein the material that forms the inert layer is doped with a P-type or N-type dopant.

**8.** The method according to any one of claims 1 to 7, wherein the silicon substrate is formed in a curved shape, and the inert layer and the silicon crystal are formed on a surface of the curved shape of the silicon substrate.

**9.** The method according to any one of claims 1 to 8, wherein the raw material gas is doped with a P-type or N-type dopant, and the dopant is switched between the P-type and the N-type during formation of the silicon thin film.

**10.** The method according to any one of claims 1 to 9, wherein the exposed face on which the inert face and the silicon thin film are exposed is formed on the silicon thin film, and a new silicon thin film is formed on the silicon thin film.

**11.** The method according to any one of claims 1 to 10, wherein, on at least one side of a peripheral edge area of the silicon substrate, an area ratio of the inert face to the exposed face is higher than that in a center area of the silicon substrate.

**12.** A method of manufacturing a silicon thin-film photovoltaic cell, wherein electrodes are formed on both faces of the silicon thin film that is formed according to any one of claims 1 to 11.

**13.** A silicon thin film that is formed by a silicon crystal and has a plurality of convex portions arranged on a principal face thereof,
wherein the convex portions have a width in the range of 0.001 µm to 0.8 µm and have peeling-off marks that are formed in a form of tearing off the silicon crystal and/or etching marks that are formed in a form acquired by removing a silicon oxide film formed on tip ends of the convex portions through etching at the tip ends of the convex portions.

**14.** The silicon thin film according to claim 13,
wherein a thickness of the silicon thin film is 40 µm or less,
wherein the width of the convex portion is 0.45 µm or less,
and wherein the etching mark is included at the tip end of the convex portion.

**15.** A thin-film photovoltaic cell that is formed by forming electrodes on both faces of the silicon thin film according to claim 13 or 14.
We amended the claim 1 to clarify that the silicon thin film can be peeled off from the silicon substrate while the silicon crystal formed on the exposed face is extended and peeled off. This feature of the amendment of the claim 1 is not disclosed in all the references cited in the international search report.
We amended the claim 13 to clarify that the maximum size of the width of the convex portions arranged on the silicon thin film is 0.8 µm. This feature of the amendment of the claim 13 is not disclosed in all the references cited in the international search report.
The claims 2-12, 14-15 are remained unchanged.
The claims 2-8, 11, 14 are admitted that they are not disclosed in all the references cited in the international search report, and have novelty and unobviousness.
The claim 9 is dependent on the claims 1-8.
The claim 12 is dependent on the claims 1-11.
The claim 15 is dependent on the claims 13, 14.
